# EUROPEAN PATENT SPECIFICATION

(11) **EP 0 360 540 B1**
(45) Date of publication and mention of the grant of the patent: **03.08.1994**
(21) Application number: 89309471.4
(22) Date of filing: 19.09.1989
(51) Int. Cl.: H03K 19/177

(54) **Programmable logic device**
Programmierbare logische Schaltung
Circuit de logique programmable

(30) Priority: 20.09.1988 JP 235293/88
(43) Date of publication of application: 28.03.1990
(73) Proprietor: KAWASAKI STEEL CORPORATION, Kobe-shi Hyogo-ken 651 (JP)
(72) Inventor: Sakamoto, Makoto, Chiba-shi Chiba 280 (JP)
(74) Representative: Stebbing, Timothy Charles

(56) References cited:
- EP-A- 0 177 261
- ELECTRO/87 AND MINI/MICRO NORTHEAST, vol. 12, 1987, Conference Record, pages19/4/1-19/4/9, Los Angeles, CA, US; P. WYNN: "Designing with logic cell arrays"
- JOURNAL OF THE ASSOCIATION FOR COMPUTING MACHINERY, vol. 14, no. 2, April 1967,pages 203-240, New York, US; R.C. MINNICK: "A survey of microcellular research"

## Description

The present invention relates to a programmable logic device (PLD) which permits a user to electrically program an arbitrary logic circuit by himself.

A known PLD primarily includes a programmable logic element (hereinafter simply referred to as a PLE) which is configurable to construct a user's own logic, a circuit function-defining memory cell for defining the logic function of the PLE and an interconnection relation among internal wirings, a programmable input/output block (hereinafter simply referred to as an IOB) for interfacing between external device packaging pins and an internal logic circuit (i.e. the PLE), and programmable wiring for establishing a wiring path to connect input/output signals into/from the IOB and the PLE to a desired network.

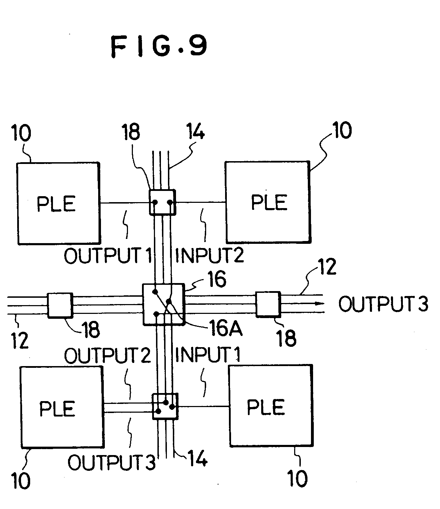

The programmable wiring is hitherto comprised, as illustrated for example in Fig. 9, of horizontal wirings 12 disposed between adjacent lines of the respective PLEs 10 (IOBs), vertical wirings 14 disposed between adjacent columns of the respective PLEs 10 (and IOBs), switching matrixes 16 including interwiring switches 16A each disposed at intersections of the lines and the columns of the respective horizontal and vertical wirings 12 and 14 for interconnecting the wirings from the adjacent columns and lines, and input/output switches (hereinafter referred to as IOSs) 18 each disposed at a position, corresponding to adjacent PLEs 10, along the respective wirings 12 and 14 for connecting inputs and outputs into and from the adjacent PLEs 10 to the wirings 12 or 14.

The interwiring switches 16A and IOSs 18 are controllable by circuit function-defining data for establishing an arbitrary wiring pattern.

However, in such a prior art PLD, the IOSs 18 of the respective PLEs 10 and the interwiring switches 16A are independently provided. Therefore, an interconnection between two PLEs 10 always requires two IOSs 18 and at least one switching matrix 18 regardless of whether the PLEs are widely separated or adjacent to each other. This necessitates an increased number of switches and complicated wiring, resulting in a large occupation area of the PLD. Additionally, there are required many gates or switches, through which associated signals pass, thereby attenuating the signals and lowering the reliability of the device.

In view of the drawbacks of the prior art, it is desired to provide a PLD capable of optimising a programmable wiring and of achieving a high functionality and reduced occupation area thereof.

A paper by P. Wynn in Electro/87 and Mini/Micro Northeast, vol. 12, 1987, Conference Record, pages 19/4/1 to 19/4/9, Los Angeles, U.S.A., discloses a programmable logic device (logic cell array) having the features of the preamble of accompanying claim 1. In this device, the "first wirings" (direct interconnect) are in the form of special-purpose wirings connecting adjacent PLEs (configurable logic blocks) without passing through the switch stations.

EP-A-0 177 261 by Xilinx, Inc. discloses a programmable logic device with similar features to the device disclosed in the above paper by P. Wynn. Again, connections between adjacent PLEs are provided by special-purpose wirings which avoid the switch stations.

According to the present invention, there is provided a programmable logic device including a rectangular array of programmable logic elements connected to each other through programmable wiring, said programmable wiring comprising:-
a rectangular array of switch stations interposed between the programmable logic elements such that each switch station not at the periphery of the array is surrounded by four adjacent programmable logic elements;
first wirings for connecting adjacent programmable logic elements; and
second wirings, separate from said first wirings, for directly connecting adjacent switch stations;
each non-peripheral switch station including four groups of second input/output terminals provided only for direct connections with adjacent switch stations via said second wirings, and switch elements for interconnecting the second input/output terminals internally within the switch stations;
characterised in that each non-peripheral switch station further includes four groups of first input/output terminals, separate from said second input/output terminals, and provided only for direct connections with its adjacent programmable logic elements via said first wirings.

The present inventors have found in their investigation of many design examples that most (over 60%) of wirings among the PLEs are used for interconnecting adjacent PLEs.

The present invention, which is based upon such investigations, facilitates interconnection between adjacent PLEs to achieve a high functionality and reduced occupation area.

In a primary aspect of the present invention, as illustrated in Fig. 1, the aforementioned programmable wiring comprises a plurality of switch stations (hereinafter simply referred to as SSs) 20, first wirings 22 located diagonally in the Figure each for directly connecting some of the input/output terminals of the SSs 20 to the adjacent PLEs 10, and second wirings 24 located vertically and horizontally in the Figure for directly connecting other input/output terminals of the SSs 20 to the adjacent SSs. Here, the PLE 10 may include the input/output terminals: A, Din, B, C, RD, W, Y, K, D, Z, CE and X, as illustrated in Fig. 2 for example. Likewise, the SS 20 may include the input/output terminals: Y, K, D, W1 to W4, Z, CE, X, S1 to S4, A, Din, B, E1 to E4, W, RD, C and N1 to N4, as illustrated in Fig. 3 for example.

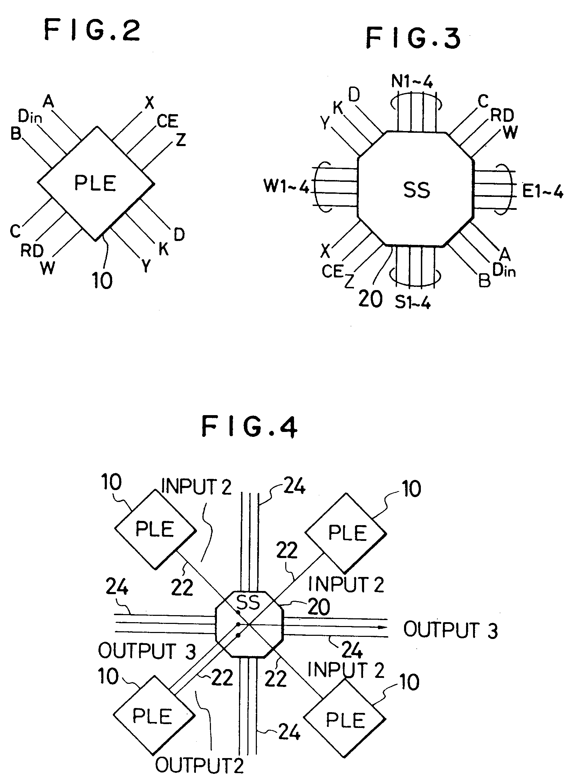

Thereby, as illustrated in Fig. 4, the number of switches through which a certain signal passes can be reduced to a fraction of that needed with the IOSs of the prior art. In particular, two adjacent PLEs 10 can be interconnected through only one SS 20.

Additionally, the direction of a wiring, through which an associated signal is transmitted, connected to the SS 20, can be clarified to make clear a relationship between the input and output of the SS 20. Consequently, there is no need for unnecessary switching among the outputs of the SS 20, unlike in the prior art. Thus, any wiring path which is not in need of connection can be easily identified, allowing optimisation of the circuit by reducing the number of switches.

Furthermore, if there are any equivalent PLE input/outputs, then they can easily be taken into consideration, so that flexibility of the wiring is less reduced even when a circuit construction is adopted with a reduced number of switches and with many restrictions.

In accordance with the present invention, as described above, there is no need to provide the IOS of the prior art and hence the number of switches can be reduced, thereby allowing the amount of wiring to be reduced, resulting in a high functionality. In particular, wiring between adjacent PLEs can be drastically reduced. In addition, the reduced number of switches helps to reduce the occupation area of the device.

Moreover, when the first and second wirings have different directions, it is easier to distinguish between them.

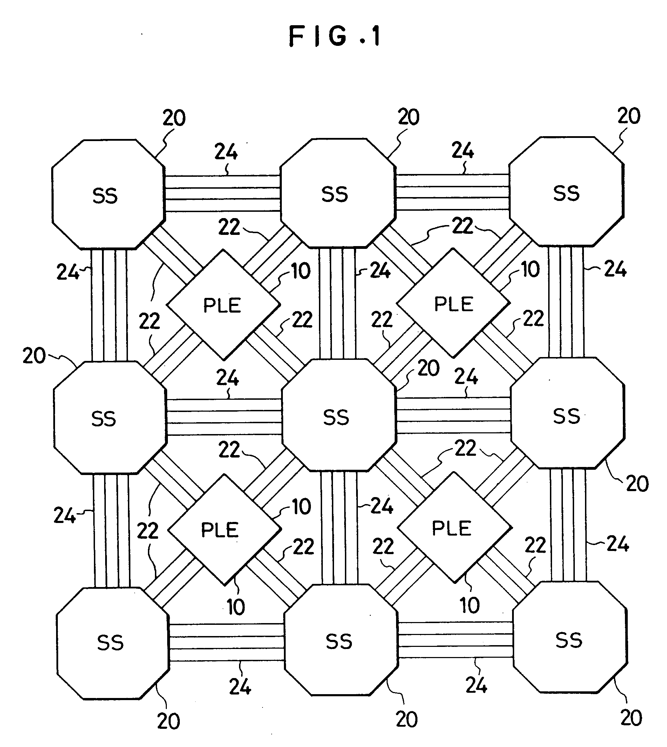

Reference is made, by way of example, to the accompanying drawings, in which:-
Fig. 1 is a block diagram illustrating the basic arrangement of a programmable logic device (PLD) according to the present invention;
Fig. 2 is a block diagram exemplarily illustrating input/output terminals of a programmable logic element (PLE) for use in the PLD of Fig. 1;
Fig. 3 is a block diagram exemplarily illustrating input/output terminals of a switch station (SS) for use in the PLD of Fig. 1;
Fig. 4 is a block diagram illustrating the function of the PLD according to the present invention;

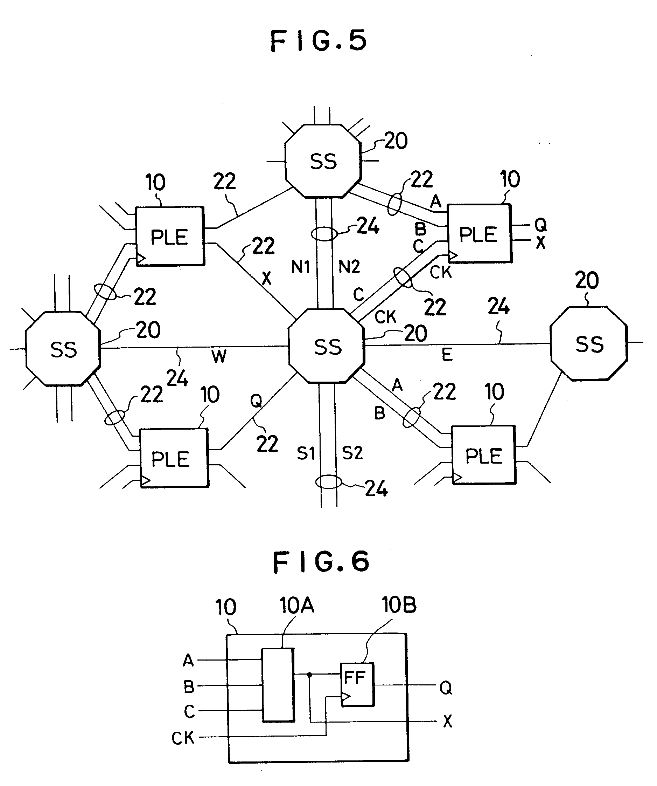

Fig. 5 is a block diagram illustrating the construction of an embodiment of the PLD according to the present invention;
Fig. 6 is a block diagram illustrating the construction of a PLE for use in the embodiment;

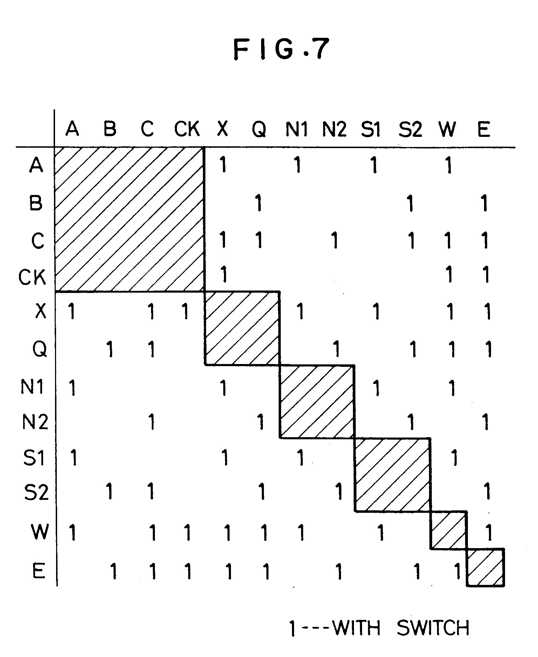

Fig. 7 is a block diagram exemplarily illustrating a switch table of a switch station for use in the embodiment of Fig. 5;

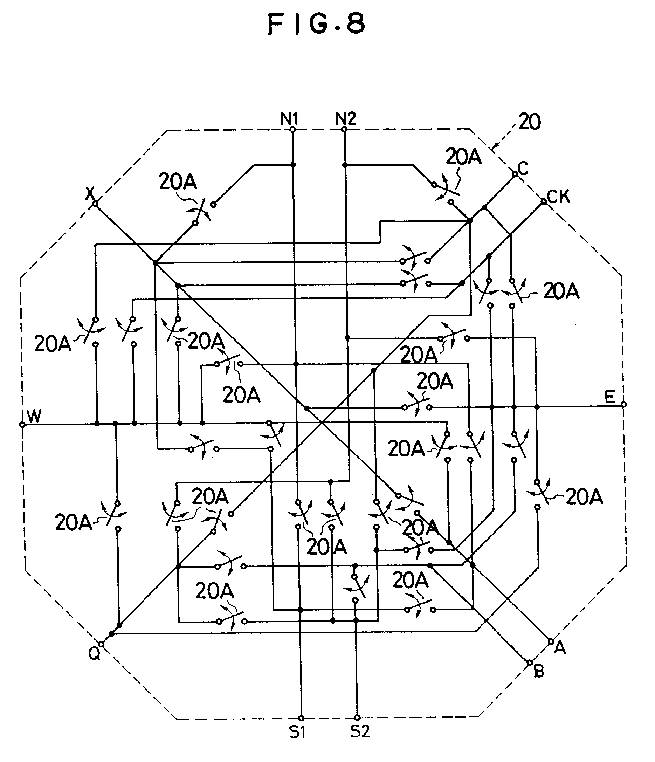

Fig. 8 is a circuit diagram exemplarily illustrating a circuit of the switch station constructed on the basis of the switch table of Fig. 7; and
Fig. 9 is a block diagram exemplarily illustrating a prior PLD including a prior programmable wiring.

In what follows, a preferred embodiment according to the present invention will be described in detail with reference to the accompanying drawings.

As shown in Fig. 5, the embodiment provides a PLD which includes a plurality of PLEs 10 connected to each other through a programmable wiring. The programmable wiring comprises a plurality of SSs 20, each of which has a plurality of input/output terminals, X, W, Q, S1, S2, B, A, E, CK, C, N1 and N2 and includes a switch 20A as shown in Fig. 8. for interconnecting the input/output terminals to each other, first wirings 22 located diagonally in the figure for directly connecting some terminals X, Q, B, A, CK and C of the input/output terminals of the SS 20 to the adjacent PLEs 10, and second wirings 24 located horizontally and vertically in the figure for directly connecting remaining terminals W, S1, S2, E, N1 and N2 of the input/output terminals of the SS 20 to the adjacent SSs 20.

The PLE 10 may be a sequential circuit, which includes, as illustrated in Fig. 6, a combinational logic circuit (e.g., an AND circuit) 10A, into which general purpose inputs A, B and C are inputted, and a flip-flop 10B for delaying a logic output X from the logic circuit 10A in response to a clock CK to generate an output Q.

The SS 20 may be one which realizes a switch table such as for example, that illustrated in Fig. 7. The SS 20 which realizes such a switch table of Fig. 7, may be constructed, as illustrated in Fig. 8 for example, with many switch elements 20A.

In the present embodiment, an arbitrary sequential circuit can be assured by programming a required function in each PLE 10, which is a sequential circuit, as well as wiring in the SS 20.

In accordance with the present embodiment, the first wirings 22 have particular directions (diagonal directions) of wiring and the second wirings 24 have other directions (up-down and right-left directions) of wiring different from the first wirings 22, thereby facilitating the discrimination of any wiring among the wirings.

Although in the above embodiment the PLE 10 is a sequential circuit including the combinational logic circuit 10A and the flip-flop 10B, the PLE 10 may be constructed without limitation thereto.

Additionally, the switch table, which can be realized by the SS 20, and the practice thereof are also not limited to the present embodiment.

## Claims

1. A programmable logic device including a rectangular array of programmable logic elements (10) connected to each other through programmable wiring, said programmable wiring comprising:-
a rectangular array of switch stations (20) interposed between the programmable logic elements (10) such that each switch station not at the periphery of the array is surrounded by four adjacent programmable logic elements;
first wirings (22) for connecting adjacent programmable logic elements (10); and
second wirings (24), separate from said first wirings, for directly connecting adjacent switch stations (20);
each non-peripheral switch station including four groups of second input/output terminals provided only for direct connections with adjacent switch stations via said second wirings, and switch elements (20A) for interconnecting the second input/output terminals internally within the switch stations;
characterised in that each non-peripheral switch station further includes four groups of first input/output terminals, separate from said second input/output terminals, and provided only for direct connections with its adjacent programmable logic elements via said first wirings.

2. A programmable logic device according to claim 1 wherein the first wirings (22) and the second wirings (24) have directional orientations different from each other.

3. A programmable logic device according to claim 1 wherein the switch elements (20A) of each switch station (20) realise a predetermined switch table.

4. A programmable logic device according to claim 1 wherein said programmable logic element (10) is a sequential circuit which comprises a combinational logic circuit (10A), for receiving at least one input, and a flip-flop (10B) for delaying a logical output from said logic circuit in response to a clock signal (CK), to generate a delayed output (Q).

5. A programmable logic device according to claim 1, wherein the first wirings (22) are orientated diagonally with respect to said rectangular arrays so as to connect each non-peripheral switch station (20) to its four adjacent programmable logic elements (10).

## Patentansprüche

1. Programmierbares Logikgerät, enthaltend ein rechteckiges Feld von programmierbaren Logikelementen (10), die untereinander durch eine programmierbare Verdrahtung verbunden sind, wobei die programmierbare Verdrahtung umfaßt
ein rechteckiges Feld von Schaltstationen (20), so zwischen die programmierbaren Logikelemente (10) geschaltet, daß jede innere Schaltstation von vier benachbarten, programmierbaren Logikelementen umgeben ist;
erste Verdrahtungen (22) zum Verbinden benachbarter Logikelemente (10); und
zweite, von den ersten Verdrahtungen getrennte Verdrahtungen (24) zum direkten Verbinden benachbarter Schaltstationen (20),
wobei jede innere Schaltstation vier Gruppen von zweiten Eingangs-Ausgangs-Anschlüssen enthält, die nur zum direkten Verbinden mit benachbarten Schaltstationen über die zweiten Verdrahtungen bereitgestellt sind, sowie Schaltelemente (20A) zum internen Verbinden der zweiten Eingangs-Ausgangs-Anschlüsse innerhalb der Schaltstationen;
dadurch gekennzeichnet, daß jede innere Schaltstation zudem vier Gruppen von ersten Eingangs-Ausgangs-Anschlüssen enthält, die von den zweiten Eingangs-Ausgangs-Anschlüssen getrennt sind und nur zum direkten Verbinden mit ihren benachbarten, programmierbaren Logikelementen über die ersten Verdrahtungen bereitgestellt sind.

2. Programmierbares Logikgerät nach Anspruch 1, wobei die ersten Verdrahtungen (22) und die zweiten Verdrahtungen (24) voneinander verschiedene Richtungen haben.

3. Programmierbares Logikgerät nach Anspruch 1, wobei die Schaltelemente (20A) jeder Schaltstation (20) eine vorbestimmte Verknüpfungstabelle verwirklichen.

4. Programmierbares Logikgerät nach Anspruch 1, wobei das programmierbare Logikelement (10) eine sequentielle Schaltung ist, enthaltend eine kombinatorische Logikschaltung (10A) zum Empfang mindestens eines Eingangssignals; und ein Flip-Flop (10B) zum Verzögern eines logischen Ausgangssignals als Reaktion auf ein Taktsignal CK, wodurch ein verzögertes Ausgangssignal (Q) erzeugt wird.

5. Programmierbares Logikgerät nach Anspruch 1, wobei die ersten Verdrahtungen (22) bezüglich der rechteckigen Felder diagonal ausgerichtet sind, so daß jede innere Schaltstation (20) mit ihren vier benachbarten, programmierbaren Logikelementen verbunden ist.

## Revendications

1. Dispositif logique programmable comprenant une matrice rectangulaire d'éléments logiques programmables (10) reliés les uns aux autres par un câblage programmable, ledit câblage programmable comprenant :
- une matrice rectangulaire de postes de commutation (20) interposée entre les éléments logiques programmables (10) de telle façon que chaque poste de commutation non situé à la périphérie de la matrice soit entouré par quatre éléments logiques programmables adjacents,
- des premiers câbles (22) pour relier les éléments logiques programmables (10) adjacents, et
- des seconds câbles (24), séparés de chacun desdits premiers câbles, pour relier directement les postes de commutation (20) adjacents,
chacun des postes de commutation non situé en périphérie comprenant quatre groupes de secondes bornes d'entrée/sortie seulement prévus pour relier directement les postes de commutation adjacents à travers lesdits seconds câbles, et des éléments de commutation (20A) pour relier les secondes bornes d'entrée/sortie en interne dans les postes de commutation,
caractérisé en ce que chaque poste de commutation non situé en périphérie comprend de plus quatre groupes de premières bornes d'entrée/sortie, séparées desdites secondes bornes d'entrée/sortie, et prévus seulement pour assurer des liaisons directes avec ses éléments logiques programmables adjacents à travers lesdits premiers câbles.

2. Dispositif logique programmable selon la revendication 1, dans lequel les premiers câbles (22) et les seconds câbles (24) présentent des sens d'orientation différents les uns des autres.

3. Dispositif logique programmable selon la revendication 1, dans lequel les éléments de commutation (20A) de chaque poste de commutation (20) réalisent un tableau de commutation prédéterminé.

4. Dispositif logique programmable selon la revendication 1, dans lequel ledit élément logique programmable (10) est un circuit séquentiel qui comprend un circuit logique combinatoire (10A), destiné à recevoir au moins une entrée, et une bascule (10B) destinée à retarder une sortie logique dudit circuit logique en réponse à un signal d'horloge (CK), pour produire une sortie retardée (Q).

5. Dispositif logique programmable selon la revendication 1, dans lequel les premiers câbles (22) sont orientés en diagonale par rapport auxdites matrices rectangulaires de façon à relier chaque poste de commutation (20) non situé en périphérie à ses quatre éléments logiques (10) adjacents.
